# EUROPEAN PATENT APPLICATION

(11) **EP 4 658 037 A1**
(43) Date of publication of application: **03.12.2025**
(21) Application number: 25179786.6
(22) Date of filing: 30.05.2025
(51) Int. Cl.: H10H 29/851

(54) **LED LAMP WITH INFRARED OUTPUT**

(30) Priority: 31.05.2024 US 202418680892
(71) Applicant: Lumileds LLC, San Jose, CA 95131 (US)
(72) Inventor: SCHMIDT, Peter Josef, Aachen (DE); DIEDRICH, Thomas, Stolberg (DE); ZIJTVELD, Karl Adriaan, Hunsel (NL)
(74) Representative: Cohausz & Florack

(57) **Abstract**

An light emitting device, may include pump LEDs or lasers and one or more phosphors allowing the lamp to emit light with a spectral power distribution having a local minimum at a water vapor absorption band, such as at 950-990 nm. Such a device may be used in radiotherapy based on hyperthermia, providing light that penetrates tissue without risk of skin overheating. Utilizing LEDs or lasers may allow the light emitting device to achieve higher efficiency, better form factor, and lower operating temperatures than water-filtered halogen lamps utilized in radiotherapy.

## Description

### FIELD OF THE INVENTION

The invention relates generally to light emitting devices, particularly lasers or light emitting diodes (LEDs) lamps providing infrared output for radiotherapy.

### BACKGROUND

The general illumination industry has witnessed remarkable advancements in technology, with one breakthrough being the invention of Light-Emitting Diodes (LEDs). This innovation has transformed the way we perceive and experience general illumination, offering improved efficiency, durability, and versatility. Developed as a response to the limitations of traditional light source, LEDs have become a staple feature in areas like modern grounded vehicles, providing enhanced safety, aesthetics, and functionality. Another area LEDs may be useful is in therapeutic applications, such as radiotherapy through hyperthermia.

For radiotherapy based on hyperthermia, water-filtered halogen lamp light sources are typically used. Since tumors and growths may show a higher water concentration than normal body tissue, the infrared (IR) radiation of the treatment lamp can heat them to a higher extent than the surroundings and eventually initiate a reaction of the immune system. The water filter is used to absorb a part of the halogen lamp spectrum to allow for the needed tissue penetration depths without the risk of skin overheating.

Typical water filtered halogen lamp radiators show 75W power consumption to reach therapeutic irradiance levels of ~200 mW/cm² for wavelengths > 590 nm, or 175 mW/cm² for infrared only at wavelengths > 780nm, for a patient to lamp distance in the 40 cm distance range. That is, the power consumption for a halogen lamp is quite large for the irradiance levels achieved.

An issue with a water-filtered halogen light source is the bulky form factor and high lamp housing temperature, which requires a rather large distance to the irradiated surface as well as protection measures for safety reasons. As a result, therapeutic application is restricted and a certain degree of patient fixation is needed. For example, an incorporation of the light source into textiles for on-skin application or "mobile" battery-powered therapeutic treatment is not practically possible with tungsten filament light sources.

### SUMMARY

Embodiments of the invention solves these issues by providing phosphor-converted light emitting devices with spectral power distributions showing local minima in the range of the first strong water absorption band, e.g., from a range of 950 - 990 nm.

These and other embodiments, features and advantages of the present invention will become more apparent to those skilled in the art when taken with reference to the following more detailed description of the invention in conjunction with the accompanying drawings that are first briefly described.

### BRIEF DESCRIPTION OF THE DRAWINGS

Figure 1 shows a schematic cross-sectional view of an example pcLED.
Figures 2A and 2B show, respectively, cross-sectional and top schematic views of an array of pcLEDs. Figure 2C shows a schematic top view of an LED wafer from which LED arrays such as those illustrated in Figures 2A and 2B may be formed.
Figure 3A shows a schematic top view of an electronics board on which an array of pcLEDs may be mounted, and Figure 3B similarly shows an array of pcLEDs mounted on the electronic board of Figure 3A.
Figure 4A shows a schematic cross-sectional view of an array of pcLEDs arranged with respect to waveguides and a projection lens. Figure 4B shows an arrangement similar to that of Figure 4A, without the waveguides.
Figure 5 schematically illustrates an example camera flash system.
Figure 6 schematically illustrates an example display (e.g., AR/VR/MR) system.

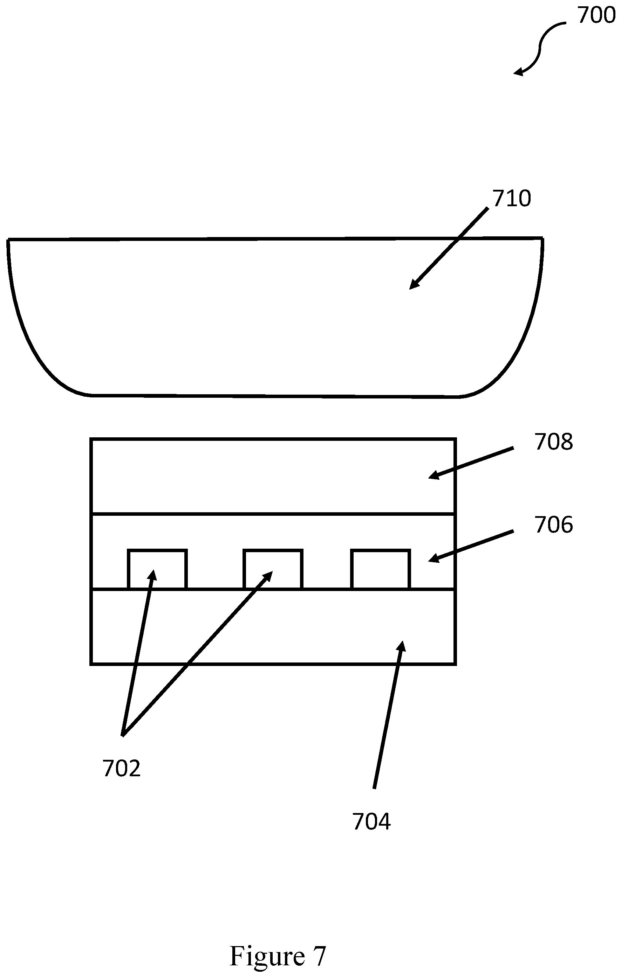

Figure 7 shows a side view of a light emitting device capable of emitting infrared light, with pump light emitters, a first and second phosphor layer, and an optical device.
Figure 8 shows a plot of spectral power distribution for phosphor layers in embodiments of the instant invention.

### DETAILED DESCRIPTION

The following detailed description should be read with reference to the drawings, in which identical reference numbers refer to like elements throughout the different figures. The drawings, which are not necessarily to scale, depict selective embodiments and are not intended to limit the scope of the invention. The detailed description illustrates by way of example, not by way of limitation, the principles of the invention. This description will clearly enable one skilled in the art to make and use the invention, and describes several embodiments, adaptations, variations, alternatives and uses of the invention.

As used in this specification and the appended claims, the singular forms "a," "an," and "the" include plural referents unless the context clearly indicates otherwise. Also, the term "parallel" is intended to mean "substantially parallel" and to encompass minor deviations from parallel geometries. The term "vertical" refers to a direction parallel to the force of the earth's gravity. The term "horizontal" refers to a direction perpendicular to "vertical." The term "on" means to be disposed to overlap (e.g., vertically) and/or to be directly in contact with.

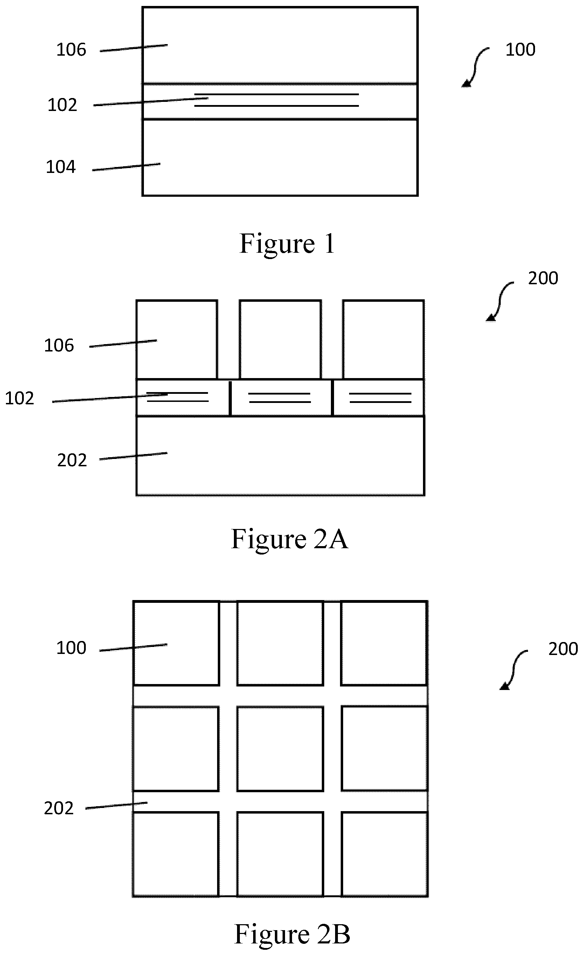

Figure 1 shows an example of an individual pcLED 100 comprising a light emitting semiconductor diode (LED) structure 102 disposed on a substrate 104, and a phosphor layer 106 (also referred to herein as a wavelength converting structure) disposed on the LED. Light emitting semiconductor diode structure 102 typically comprises an active region disposed between n-type and p-type layers. Application of a suitable forward bias across the diode structure results in emission of light from the active region. The wavelength of the emitted light is determined by the composition and structure of the active region.

The LED may be, for example, a III-Nitride LED that emits ultraviolet, blue, green, or red light. LEDs formed from any other suitable material system and that emit any other suitable wavelength of light may also be used. Other suitable material systems may include, for example, III-Phosphide materials, III-Arsenide materials, and II-VI materials.

Any suitable phosphor materials may be used, depending on the desired optical output and color specifications from the pcLED. Phosphor layers may for example comprise phosphor particles dispersed in or bound to each other with a binder material, or be or comprise a sintered ceramic phosphor plate.

Figures 2A-2B show, respectively, cross-sectional and top views of an array 200 of pcLEDs 100 including phosphor layers 106 disposed on a substrate 202. Such an array may include any suitable number of pcLEDs arranged in any suitable manner. In the illustrated example the array is depicted as formed monolithically on a shared substrate, but alternatively an array of pcLEDs may be formed from individual mechanically separate pcLEDs arranged on a substrate. Substrate 202 may optionally comprise CMOS circuitry for driving the LED and may be formed from any suitable materials.

Although Figures 2A-2B show a three-by-three array of nine pcLEDs, such arrays may include for example tens, hundreds, or thousands of LEDs. Individual LEDs may have widths (e.g., side lengths) in the plane of the array of, for example, less than or equal to 1 millimeter (mm), less than or equal to 500 microns, less than or equal to 100 microns, or less than or equal to 50 microns. LEDs in such an array may be spaced apart from each other by streets or lanes having a width in the plane of the array of, for example, hundreds of microns, less than or equal to 100 microns, less than or equal to 50 microns, less than or equal to 10 microns, or less than or equal to 5 microns.

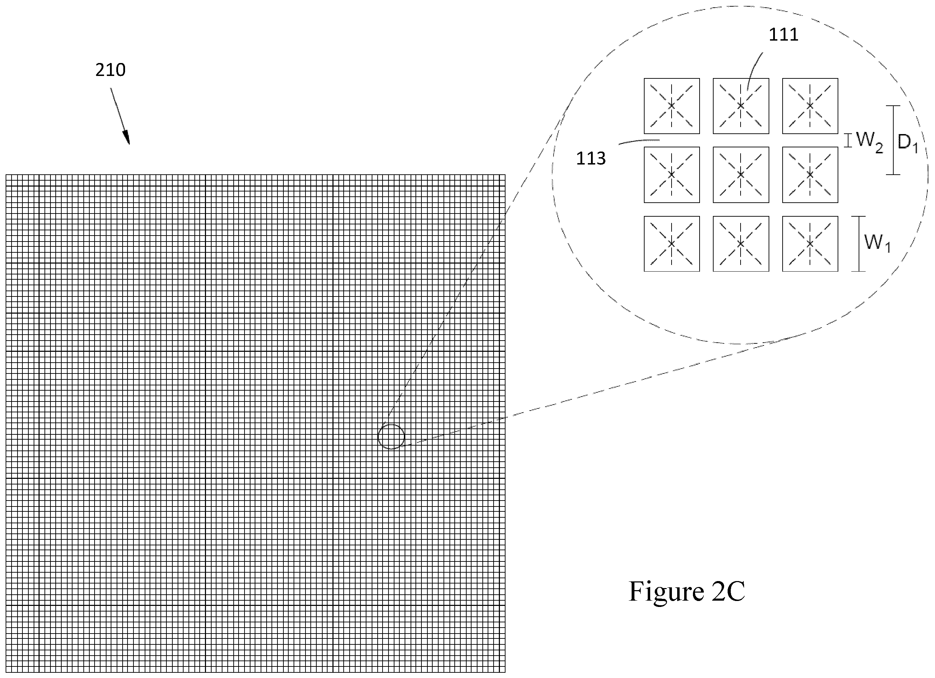

Figure 2C shows a schematic top view of a portion of an LED wafer 210 from which LED arrays such as those illustrated in Figures 2A and 2B may be formed. Figure 2C also shows an enlarged 3x3 portion of the wafer. In the example wafer individual LEDs or pcLEDs 111 having side lengths (e.g., widths) of W1 are arranged as a square matrix with neighboring LEDs or pcLEDs having a center-to-center distances D1 and separated by lanes 113 having a width W2. W1 may be, for example, less than or equal to 1 millimeter (mm), less than or equal to 500 microns, less than or equal to 100 microns, less than or equal to 50 microns, or less than or equal to 10 microns. W2 may be, for example, hundreds of microns, less than or equal to 100 microns, less than or equal to 50 microns, less than or equal to 10 microns, or less than or equal to 5 microns. D1 = W1 + W2.

An array may be formed, for example, by dicing wafer 210 into individual LEDs or pcLEDs and arranging the dice on a substrate. Alternatively, an array may be formed from the entire wafer 210, or by dividing wafer 210 into smaller arrays of LEDs or pcLEDs.

LEDs having dimensions in the plane of the array (e.g., side lengths) of less than or equal to about 50 microns are typically referred to as microLEDs, and an array of such microLEDs may be referred to as a microLED array.

Although the illustrated examples show rectangular LEDs or pcLEDs arranged in a symmetric matrix, the LEDs or pcLEDs and the array may have any suitable shape or arrangement and need not all be of the same shape or size. For example, LEDs or pcLEDs located in central portions of an array may be larger than those located in peripheral portions of the array. Alternatively, LEDs or pcLEDs located in central portions of an array may be smaller than those located in peripheral portions of the array.

In an array of pcLEDs, all pcLEDs may be configured to emit essentially the same spectrum of light. Alternatively, a pcLED array may be a multicolor array in which different pcLEDs in the array may be configured to emit different spectrums (colors) of light by employing different phosphor compositions. Similarly, in an array of direct emitting LEDs (i.e., not wavelength converted by phosphors) all LEDs in the array may be configured to emit essentially the same spectrum of light, or the array may be a multicolor array comprising LEDs configured to emit different colors of light.

The individual LEDs or pcLEDs in an array may be individually operable (addressable) and/or may be operable as part of a group or subset of (e.g., adjacent) LEDs or pcLEDs in the array.

An array of LEDs or pcLEDs, or portions of such an array, may be formed as a segmented monolithic structure in which individual LEDs or pcLEDs are electrically isolated from each other by trenches and/or insulating material, but the electrically isolated segments remain physically connected to each other by portions of the semiconductor structure.

An LED or pcLED array may therefore be or comprise a monolithic multicolor matrix of individually operable LED or pcLED light emitters. The LEDs or pcLEDs in the monolithic array may for example be microLEDs as described above.

A single individually operable LED or pcLED or a group of adjacent such LEDs or pcLEDs may correspond to a single pixel (picture element) in a display. For example, a group of three individually operable adjacent LEDs or pcLEDs comprising a red emitter, a blue emitter, and a green emitter may correspond to a single color-tunable pixel in a display.

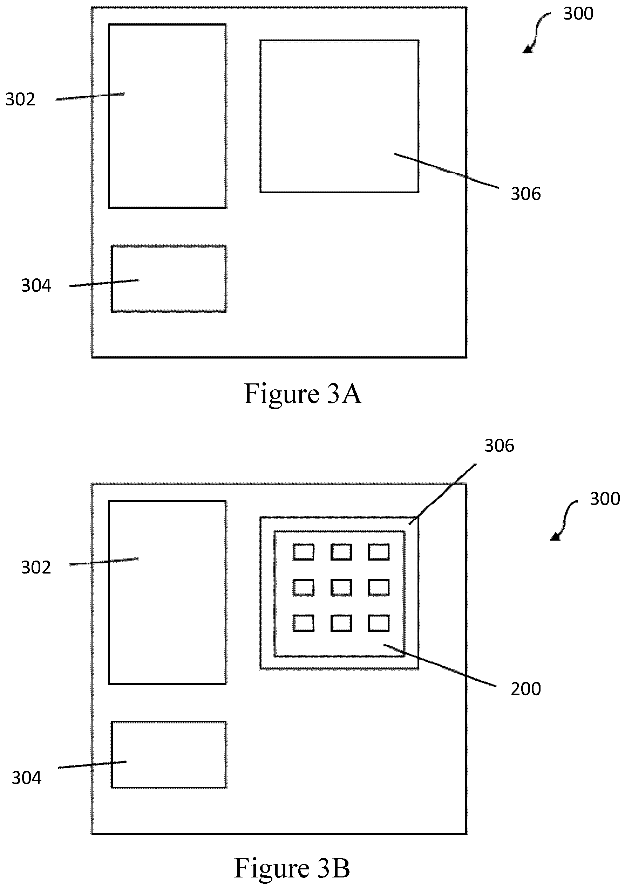

As shown in Figures 3A-3B, an LED or pcLED array 200 may be mounted on an electronics board 300 comprising a power and control module 302, a sensor module 304, and an attach region 306. Power and control module 302 may receive power and control signals from external sources and signals from sensor module 304, based on which power and control module 302 controls operation of the LEDs/pcLEDs. Sensor module 304 may receive signals from any suitable sensors, for example from temperature or light sensors. Alternatively, array 200 may be mounted on a separate board (not shown) from the power and control module and the sensor module.

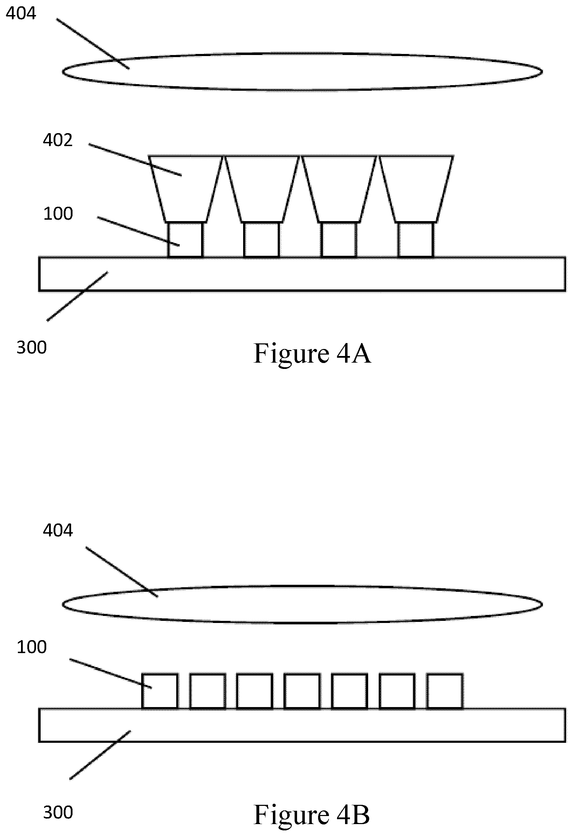

Individual LEDs or pcLEDs may optionally incorporate or be arranged in combination with a lens or other optical element located adjacent to or disposed on the phosphor layer. Such an optical element, not shown in the figures, may be referred to as a "primary optical element". In addition, as shown in Figures 4A-4B an array 200 (for example, mounted on an electronics board 300) may be arranged in combination with secondary optical elements such as waveguides, lenses, or both for use in an intended application. In Figure 4A, light emitted by pcLEDs 100 is collected by waveguides 402 and directed to projection lens 404. Projection lens 404 may be a Fresnel lens, for example. This arrangement may be suitable for use, for example, in automobile headlights. In Figure 4B, light emitted by pcLEDs 100 is collected directly by projection lens 404 without use of intervening waveguides. This arrangement may be particularly suitable when LEDs or pcLEDs can be spaced sufficiently close to each other and may also be used in automobile headlights as well as in camera flash applications. A microLED display application may use similar optical arrangements to those depicted in Figures 4A-4B, for example.

In another example arrangement, a central block of LEDs or pcLEDs in an array may be associated with a single common (shared) optic, and edge LEDs or pcLEDs located in the array at the periphery of the central bloc are each associated with a corresponding individual optic.

Generally, any suitable arrangement of optical elements may be used in combination with the LED and pcLED arrays described herein, depending on the desired application.

LED and pcLED arrays as described herein may be useful for applications requiring or benefiting from fine-grained intensity, spatial, and temporal control of light distribution. These applications may include, but are not limited to, precise special patterning of emitted light from individual LEDs or pcLEDs or from groups (e.g., blocks) of LEDs or pcLEDs. Depending on the application, emitted light may be spectrally distinct, adaptive over time, and/or environmentally responsive. Such arrays may provide pre-programmed light distribution in various intensity, spatial, or temporal patterns. The emitted light may be based at least in part on received sensor data and may be used for optical wireless communications. Associated electronics and optics may be distinct at an individual LED / pcLED, group, or device level.

An array of independently operable LEDs or pcLEDs may be used in combination with a lens, lens system, or other optic or optical system (e.g., as described above) to provide illumination that is adaptable for a particular purpose. For example, in operation such an adaptive lighting system may provide illumination that varies by color and/or intensity across an illuminated scene or object and/or is aimed in a desired direction. Beam focus or steering of light emitted by the LED or pcLED array can be performed electronically by activating LEDs or pcLEDs in groups of varying size or in sequence, to permit dynamic adjustment of the beam shape and/or direction without moving optics or changing the focus of the lens in the lighting apparatus. A controller can be configured to receive data indicating locations and color characteristics of objects or persons in a scene and based on that information control LEDs or pcLEDs in an array to provide illumination adapted to the scene. Such data can be provided for example by an image sensor, or optical (e.g., laser scanning) or non-optical (e.g., millimeter radar) sensors. Such adaptive illumination is increasingly important for automotive (e.g, adaptive headlights), mobile device camera (e.g., adaptive flash), VR, and AR applications such as those described below.

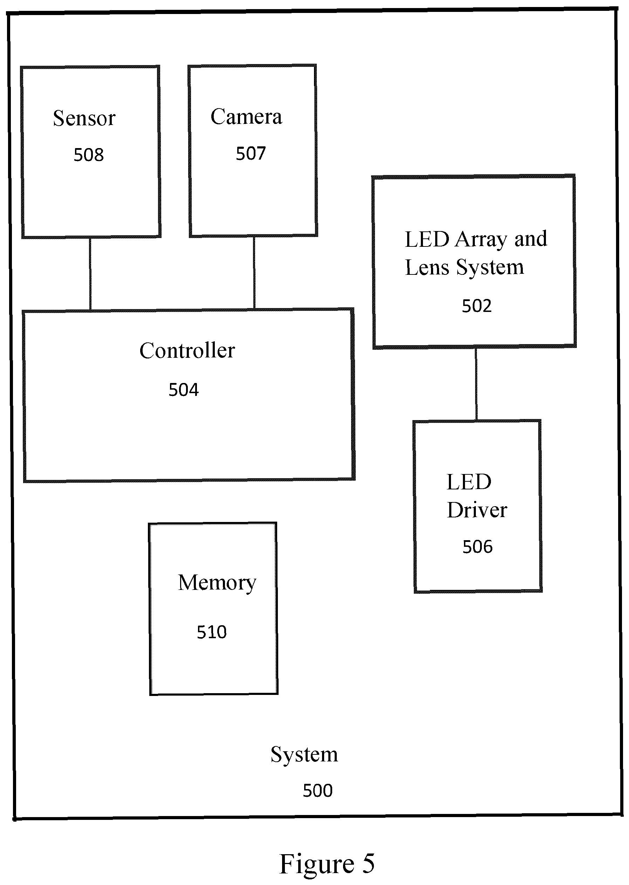

Figure 5 schematically illustrates an example camera flash system 500 comprising an LED or pcLED array and lens system 502, which may be or comprise an adaptive lighting system as described above in which LEDs or pcLEDs in the array may be individually operable. In operation of the camera flash system, illumination from some or all of the LEDs or pcLEDs in array and lens system 502 may be adjusted - deactivated, operated at full intensity, or operated at an intermediate intensity. The array may be a monolithic array, or comprise one or more monolithic arrays, as described above. The array may be a microLED array, as described above.

Flash system 500 also comprises an LED driver 506 that is controlled by a controller 504, such as a microprocessor. Controller 504 may also be coupled to a camera 507 and to sensors 508 and operate in accordance with instructions and profiles stored in memory 510. Camera 507 and LED or pcLED array and lens system 502 may be controlled by controller 504 to, for example, match the illumination provided by system 502 (i.e., the field of view of the illumination system) to the field of view of camera 507, or to otherwise adapt the illumination provided by system 502 to the scene viewed by the camera as described above. Sensors 508 may include, for example, positional sensors (e.g., a gyroscope and/or accelerometer) and/or other sensors that may be used to determine the position and orientation of system 500.

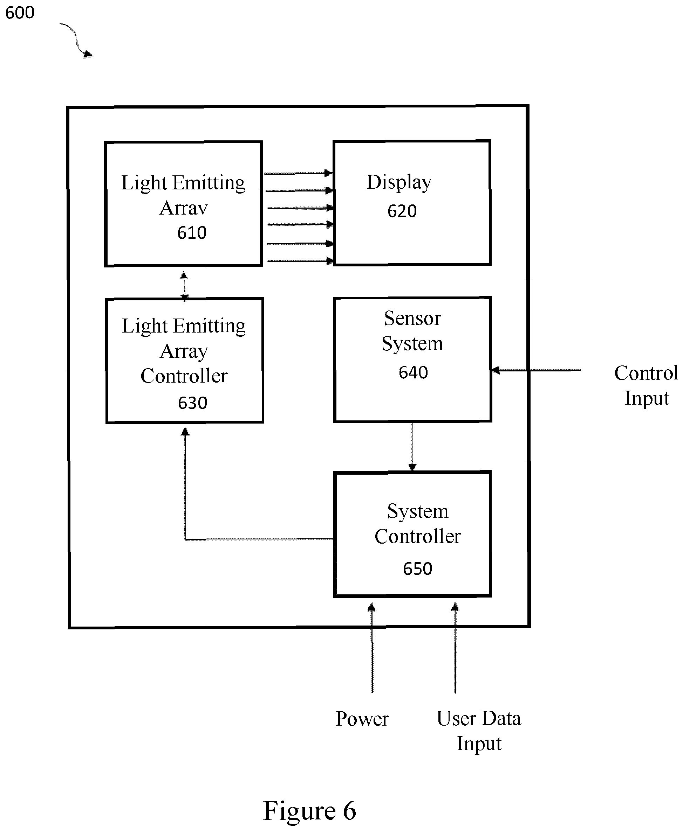

Figure 6 schematically illustrates an example display (e.g., AR/VR/MR) system 600 that includes an array 610 of individually operable LEDs or pcLEDs, a display 620, a light emitting array controller 630, a sensor system 640, and a system controller 650. Array 610 may be a monolithic array, or comprise one or more monolithic arrays, as described above. The array may be monochromatic. Alternatively, the array may be a multicolor array in which different LEDs or pcLEDs in the array are configured to emit different colors of light, as described above. The array may therefore be or comprise a monolithic multicolor matrix of individually operable LED or pcLED light emitters, which may for example be microLEDs as described above. A single individually operable LED or pcLED or a group of adjacent such LEDs or pcLEDs in the array may correspond to a single pixel (picture element) in the display. For example, a group of three individually operable adjacent LEDs or pcLEDs comprising a red emitter, a blue emitter, and a green emitter may correspond to a single color-tunable pixel in the display. Array 610 can be used to project light in graphical or object patterns that can support AR/VR/MR systems

Control input is provided to the sensor system 640, while power and user data input is provided to the system controller 650. In some embodiments modules included in system 600 can be compactly arranged in a single structure, or one or more elements can be separately mounted and connected via wireless or wired communication. For example, array 610, display 620, and sensor system 640 can be mounted on a headset or glasses, with the light emitting array controller and/or system controller 650 separately mounted.

System 600 can incorporate a wide range of optics (not shown) to couple light emitted by array 610 into display 620. Any suitable optics may be used for this purpose.

Sensor system 640 can include, for example, external sensors such as cameras, depth sensors, or audio sensors that monitor the environment, and internal sensors such as accelerometers or two or three axis gyroscopes that monitor an AR/VR/MR headset position. Other sensors can include but are not limited to air pressure, stress sensors, temperature sensors, or any other suitable sensors needed for local or remote environmental monitoring. In some embodiments, control input can include detected touch or taps, gestural input, or control based on headset or display position.

In response to data from sensor system 640, system controller 650 can send images or instructions to the light emitting array controller 630. Changes or modification to the images or instructions can also be made by user data input, or automated data input as needed. User data input can include but is not limited to that provided by audio instructions, haptic feedback, eye or pupil positioning, or connected keyboard, mouse, or game controller.

As noted above, LEDs or lasers may be combined with one or more phosphors in order to provide the spectral power distributions for radiotherapy.

Embodiments of the invention include a light emitting device 700 may include one or more primary light sources 702 (e.g., blue emitting, such as having a peak wavelength in the range of 450-495 range; or white light) such as an LED or a laser diode, and at least one phosphor material 706 that can be excited by the emission of the primary light source 702 to emit light of an IR frequency. The primary light sources 702 may be disposed on a substrate 704. The primary light sources 702 may number anywhere from, for example, 1-500, such as 50-400, such as 100-200. The light emitting device 700 may be in a CoB (chip on board) configuration, where the primary light sources 702 are LED chips are disposed in direct contact with a common substrate 704. The substrate 704 may act as a heat sink to transfer heat away from the LED chips. All the LED chips on the substrate 704 may be electrically connected to each other, and the array of LED chips may be connected to a positive and negative terminal provided on, as, and/or through the substrate 704. The primary light sources 702 may be spaced apart from each other, or in direct contact with one another, e.g., via their sidewalls. The phosphor material 706 may encapsulate the primary light sources 702 by being in direct contact with their top light emitting surfaces and/or their sidewalls. Alternatively, the phosphor material 706 may be spaced out from the primary light sources 702 without being in direct contact with them. For example, the phosphor material 706 could be placed at the end of an optical fiber that acts as a waveguide and transports the primary excitation light to the phosphor material 706 to generate the IR light. The fiber optic may be placed into a needle or a catheter.

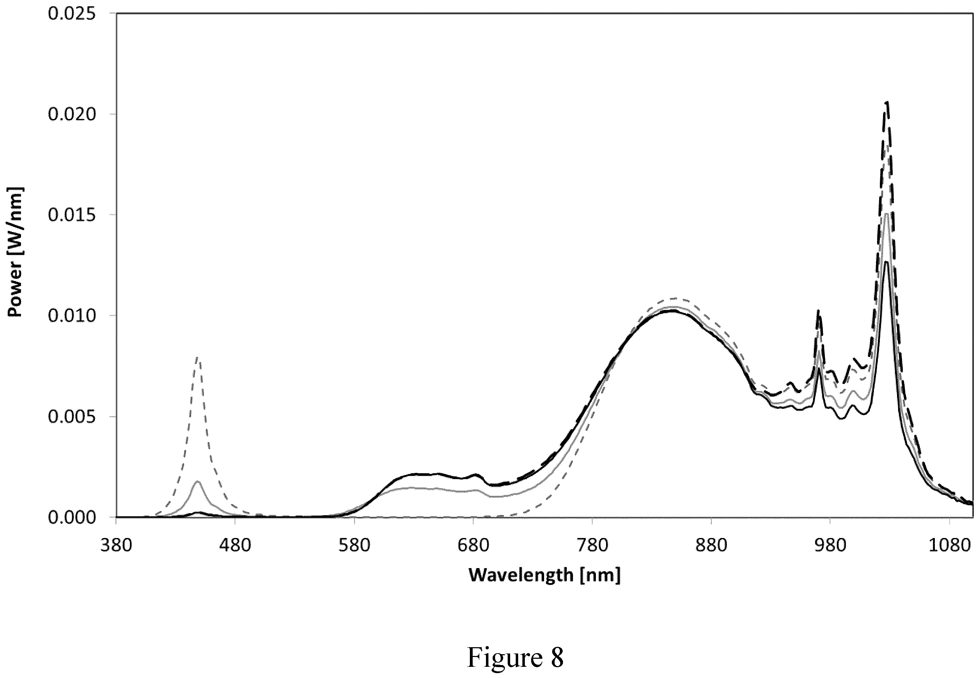

The phosphor material 706 may emit light of a different peak wavelength than that of the primary light source 702 used to excite it. That is, the phosphor material 706 may emit non-visible light with a peak wavelength in the IR/NIR range (e.g., 800-2500 nm, such as 700-1200 nm, such as from 750-1100 nm). The phosphor material 706 may emit no visible light due to excitation; alternatively, it may emit some visible light due to excitation, in addition to the non-visible light it emits. The phosphor material 706 may include a mixture of one or more compositions of phosphors in a binder, such as silicone resin. For example, the phosphor material 706 may include two compositions of phosphors mixed together in silicone resin. The two types of phosphors may have different spectral power distributions (SPD). For example, one phosphor may have the maximum power of its emission SPD in the 700 - 900 nm range (e.g., 800-880 nm, such as 850 nm), and the other with its emission SPD maximum in the 1000 - 1100 nm range (e.g., 1020-1050 nm, such as 1040 nm). One of these may be the peak wavelength of the light emitting device 700 and the other may just be a local maximum. For example, the peak wavelength may be in the 1000-1100 nm range. If there are more than two types of phosphors in the phosphor material 706 the, a third phosphor may be a red emitting phosphor or another NIR emitting phosphor. If the third phosphor is a red emitting phosphor the peak emission should be in the 630 - 670 nm range, such as 650nm. If the third phosphor is another NIR emitting phosphor the peak emission should be shorter than 850 nm such as, e.g., 700-740 nm, e.g., 740 nm. In any case, the combination of the phosphors in the phosphor material 706 and/or the primary light source 702 emits light that is characterized by a local minimum in the range of liquid water absorption maximum (e.g. from 950 - 990 nm). This local minimum allows the light emitting device 700 to avoid skin overheating when illuminating a patient. Such a distribution is shown in Fig. 8. The SPD of the light emitting device 700 may also have SPD maximums of each of the phosphors in the phosphor material 706, and even the local minimum in 950-990 nm, each be greater than the SPD maximums of the primary light source 702 in the range of 380-480 nm. In some embodiments, the local minimum in 950-990 nm may be of lesser power than the power of the peak wavelength of the primary light source 702. In this description, power of a light may have units of W/nm may be proportional to irradiance of light. The local minimum may be between the maximum wavelengths of the two or more phosphors. The spectral power of the local minimum for the 950-990 nm range may be smaller than both the spectral power at higher energies (e.g., for the 860 - 900 nm range) and the spectral power at lower energies (e.g., for the 1020-1060 nm range).

One or both of the phosphors may include and/or be doped with chromium. The phosphor emitting the longer wavelength light may have yttrium as an emitting center. Alternatively, the phosphor material 706 may comprise only one broad emitting phosphor, and be used with a dichroic or bandpass filter on the phosphor material 706 which decreases the amount of light emitted from 950-990 nm by the light emitting device 700.

For therapy applications it may be undesirable to emit larger amounts of primary pump blue light in the visible spectral range. The light emitting device 700 may also comprise an additional phosphor material 708 that also absorbs light of the primary light sources 702 (unabsorbed by the phosphor material 706) and emits in the different wavelength/wavelength range. The additional phosphor material 708 may be disposed above the phosphor material 706, and may be in direct contact with the phosphor material 706, although this is not a requirement. The additional phosphor material 708 may include a binder which may be the same as or different than the binder of phosphor material 706, and include a different phosphor than included in the phosphor material 706. The emitted light from the additional phosphor material 708 may include and/or be light of a different wavelength range from that emitted by the phosphor material 706. For example, the additional phosphor material 708 may emit visible red light (such as light with a peak wavelength in the range of visible light, such as 620-750 nm), or visible green light. Red light may be preferred to green or blue light for eye safety reasons. Red light may cause less glare to the patient, and make the illumination look more pleasant. The additional phosphor material 708 may reduce the blue light emitted from the light emitting device 700 to 0-2% of total spectral power, such as 0-1% or 1-2%. The spectral power of blue without the additional phosphor material 708 may be for example 6-8%, such as 7%. As an example, the additional phosphor material 708 may include an Eu²⁺ doped red emitting material such as BSSNE type phosphors of composition M₂₋ₓSi_{5-y}Al_{y}O_{y}N_{8-y}:Euₓ (M=Ba, Sr, Ca), such as, for example Ba_{0.2}Ca_{0.06}Sr_{1.64}Si_{4.98}Al_{0.02}O_{0.02}N_{7.98}:Eu_{0.1}; CASN or SCASN type phosphors of composition M₁₋ₓSiAlN₃:Euₓ (M=Sr, Ca) such as, for example Ca_{0.985}SiAlN₃:Eu_{0.015}; or M₁₋ₓLiAl₃N₄:Euₓ (M=Ba, Sr, Ca) such as, for example, (Ba_{0.5}Ca_{0.5})_{0.995}LiAl₃N₄:Eu_{0.005}, which may crystallize in an ordered structure variant of the UCr₄C₄ structure type with Ba and Ca occupying specific lattice sites. Similar ordered variants are known for oxides like RbNaLi₆Si₂O₈.

Alternatively, the phosphor material 706 itself may include the phosphor described in relation to the additional phosphor material 708 rather than that phosphor being in a separate binder.

The light emitting device 700 may comprise one or more optical devices 710 which may be shared by all of the primary light sources 702. The optical devices 710 may be lenses and/or collimators, for example.

The light emitting device 700 may reach optimal therapeutic irradiance levels at shorter distances compared to halogen lamps and/or at significantly reduced input power levels. For example, embodiments of the invention may reach at or greater than 2W IR power at 10W of electrical power, using a COB with 9 mm diameter LES, saturated red color point. That is, the light emitting device 700 may have a 10-30% electrical power to IR power conversion, such as 15-25%, such as 18-20%. This may be improved over conventional water-filtered halogen lamps.

A practical example is given. In embodiments of the invention, a red emitting CASN phosphor (e.g., BR-101/K, Mitsubishi Chemical) was combined with a near-infrared (NIR) emitting pyroxene phosphor of composition Li_{0.75}Sc_{0.65}Mg_{0.5}Si₂O₆:Cr_{0.1} (LSMSO) and a NIR emitting garnet phosphor of composition Gd_{2.66}Sc_{1.75}Lu_{0.3}Ga₂AlO₁₂: Cr_{0.1},Yb_{0.2} (CY-GG) at varying percents by weight. As a pump source, 450 nm emitting InGaN LEDs in a COB with light emitting surface diameter of 9 mm was used.

The following examples of phosphor layers show variations in the red emitting phosphor content, with example 1 starting at 0% progressing up in the other examples, as shown in Table 1. While example 2 still shows a pink visible light emission due to the blue primary leakage light, the visible emission of example 3 is a saturated red color. Example 4 has slightly increased CY-GG content. All examples show an electrical to NIR power conversion in the 25% range and a NIR output (750 - 1100 nm) of > 3.4 W/cm² at the light emitting surface. The results are shown in Table 2.

**Table 1**

| **Example** | **LED type** | **Phosphor mix (wt%) in silicone resin** |
|---|---|---|
| 1 | CoB1203, LES9 | 60% LSMSO:Cr + 40% CY-GG + 0% BR-101/K |
| 2 | CoB1203, LES9 | 57% LSMSO:Cr + 38% CY-GG + 5% BR-101/K |
| 3 | CoB1203, LES9 | 51.44% LSMSO:Cr + 34.30% CY-GG + 14.26% BR-101/K |
| 4 | CoB1203, LES9 | 48.5% LSMSO:Cr + 38% CY-GG + 13.5% BR-101/K |

**Table 2**

| **Example** | **If [mA]** | **voltage [V]** | **PHIe_pump [mW]** | **PHIv [Im]** | **x** | **y** | **PHI_e (380-1100nm) [mW]** | **IR (750-1100nm) [mW]** |
|---|---|---|---|---|---|---|---|---|
| 1 | 300 | 33.85 | 7246 | 6.8 | 0.155 | 0.029 | 2670 | 2461 |
| 2 | 300 | 33.85 | 7224 | 28.5 | 0.439 | 0.218 | 2569 | 2305 |
| 3 | 300 | 33.81 | 7224 | 30.7 | 0.624 | 0.311 | 2520 | 2204 |

Figure 8 shows the spectral curves of examples 1-4 in terms of power vs wavelength. The dashed grey line is the curve for example 1, the solid grey is example 2, solid black is example 3, and dashed black is example 4. As can be seen, examples 3 and 4 have much lower amounts of light for 380-500 nm, at near zero, compared to examples 1 and 2. They have much higher amounts of light at or around the red light range, such as from 600-730 nm, because more of their pump light is converted by the phosphors.

Spectral ratios may be useful to characterize the phosphor mixtures being employed. Spectral ranges of interest may be broken up into A: 860 - 900 nm, B: 950 - 990 nm, and C: 1020 - 1060 nm. B is the range of the first strong water absorption band. A conventional water-filtered halogen lamp with visible light filter shows ratios B/A and B/C of 76% and 76%, respectively. In contrast, examples 1-4 have B/A and B/C shown in Table 3:

**Table 3**

| **Example** | **B/A** | **B/C** |
|---|---|---|
| 1 | 71% | 85% |
| 2 | 66% | 91% |
| 3 | 62% | 98% |
| 4 | 80% | 80% |

According to embodiments of the invention, B/A may be <=90%, preferably <= 80%; and B/C should be <= 100% and preferably <= 90%. B/C/ may be greater than B/A, although this is not a requirement, and they may be equal. B/A may be between 60-90%, such as between 60-80%, and B/C/ may be between 70-100%, such as between 80-90%.

The devices of the invention may be used as medical lamps or illumination systems for hyperthermia. The devices could also be used for all applications that are characterized by the terminus "photobiomodulation" or low-level laser therapy. The devices can also be used for well-being in general illumination outside a clinical setting. The devices of the invention could be used as auxiliary lamps for illumination systems comprising standard visible spectrum LED light sources.

Embodiments of this invention include a light emitting device including a plurality of light emitters comprising light emitting diodes or lasers that emit a first light having a first peak wavelength; a phosphor layer arranged in an optical path of the light emitters, the phosphor layer including two or more phosphors arranged to absorb the first light and emit a second light, the second light having a spectral distribution (SPD) including a first local maximum wavelength, a second local maximum wavelength, and a first local minimum wavelength at 950-990 nm and between the first and second local maximum wavelengths.

The light emitting device where the light emitters includes lasers.

The light emitting device where the first light has the first peak wavelength is in the range of 450-495 nm.

The light emitting device of where a first power spectral ratio of a first wavelength interval of 950-990 nm over a second wavelength interval of 860-900 nm is less than or equal to 80%.

The light emitting device of where a second power spectral ratio of a first wavelength interval of 950-990 nm over a second wavelength interval of 1020-1060 nm is less than or equal to 90%.

The light emitting device of further including a collimator arranged in an optical path of the light emitters and the phosphor layer and arranged to collimate the first and second light.

The disclosures provided in this specification are intended to illustrate but not necessarily to limit the described implementation. As used herein, the term "implementation" means an implementation that serves to illustrate by way of embodiments but not limitation. The techniques described in the preceding text and figures can be mixed and matched as circumstances demand to produce alternative implementations. It will be apparent to those of ordinary skill in the art that numerous variations, changes, and substitutions of the embodiments described above can be made without departing from the invention. Furthermore, it shall be understood that all aspects of the invention are not limited to the specific depictions, configurations or relative proportions set forth herein which depend upon a variety of conditions and variables. It should be understood that various alternatives to the embodiments of the invention described herein may be employed in practicing the invention. It is therefore contemplated that the invention shall also cover any such alternatives, modifications, variations or equivalents. All such alternatives will be apparent to one skilled in the art in light of this disclosure and are intended to fall within the scope of the appended claims.

## Claims

1. A light emitting device comprising:
a plurality of light emitters comprising light emitting diodes or lasers that emit a first light having a first peak wavelength;
a phosphor layer arranged in an optical path of the light emitters, the phosphor layer comprising two or more phosphors arranged to absorb the first light and emit a second light, the second light having a spectral distribution (SPD) comprising a first local maximum wavelength, a second local maximum wavelength, and a first local minimum wavelength at 950-990 nm and between the first and second local maximum wavelengths.

2. The light emitting device of claim 1, wherein the two or more phosphors comprise a first phosphor arranged to absorb the first light and emit a third light having a second peak wavelength that is the first local maximum wavelength, and a second phosphor arranged to absorb the first light and emit a fourth light having a third peak wavelength that is the second local maximum wavelength, such that the second light comprise the third light and a fourth light.

3. The light emitting device of claim 1 wherein the first local maximum wavelength is greater than the second local maximum wavelength, and a first power of the third light at the second peak wavelength is greater than a second power of the fourth light at the third peak wavelength.

4. The light emitting device of claim 3, wherein the phosphor layer is arranged to transmit a remaining first light after absorbing some of the first light, the remaining first light having a third power at the first peak wavelength less than the first power, the third power being equal to 0-2% of the total spectral power of light emitted by the light emitting device.

5. The light emitting device of claim 3, wherein the third power is less than the second power.

6. The light emitting device of claim 2, wherein the first local maximum wavelength is in the range of 1000-1100 nm, and the second local maximum wavelength is in the range of 700-900 nm.

7. The light emitting device of claim 2, wherein the phosphor layer comprises a third phosphor having a fourth peak wavelength different from the second and third peak wavelengths.

8. The light emitting device of claim 1, wherein the phosphor layer comprises resin encapsulating the two or more phosphors.

9. The light emitting device of claim 1, wherein the two or more phosphor comprises a first phosphor comprising chromium.

10. The light emitting device of claim 1, wherein the two or more phosphor comprises a second phosphor comprising chromium.

11. The light emitting device of claim 10, wherein the second phosphor comprises ytterbium.

12. The light emitting device of claim 10, wherein the first phosphor crystallizes in a pyroxene structure type and the second phosphor crystallizes in a garnet structure type.

13. The light emitting device of claim 10, further comprising a second phosphor layer arranged in an optical path of the light emitters, the second phosphor layer arranged to absorb the first light and emit a third light having a second peak wavelength in the visible range.

14. The light emitting device of claim 13, wherein the second peak wavelength is in a range of 620-750 nm.

15. The light emitting device of claim 1, wherein the light emitters comprise light emitting diodes.
